# EUROPEAN PATENT APPLICATION

(11) **EP 4 700 408 A1**
(43) Date of publication of application: **25.02.2026**
(21) Application number: 25755047.5
(22) Date of filing: 02.01.2025
(51) Int. Cl.: G01R 31/3842, G01R 31/385, G01R 19/165, H01M 10/48, H01M 4/505, H01M 10/44

(54) **BATTERY DIAGNOSTIC DEVICE AND METHOD**

(30) Priority: 16.02.2024 KR 20240022841
(71) Applicant: LG Energy Solution, Ltd., Seoul 07335 (KR)
(72) Inventor: CHOI, Hyun-Jun, Daejeon 34122 (KR); KIM, Tae-Hyeon, Daejeon 34122 (KR); KIM, Young-Deok, Daejeon 34122 (KR); KIM, Dae-Soo, Daejeon 34122 (KR)
(74) Representative: Goddar, Heinz J.
(86) International application number: PCT/KR2025/000052
(87) International publication number: WO 2025/173925

(57) **Abstract**

A method for diagnosing a battery according to one aspect of the present disclosure diagnoses a battery having a positive electrode to which an active material is applied, and the method includes a differential profile generating step of generating a differential profile representing a corresponding relationship between a differential capacity obtained by differentiating a capacity of the positive electrode with respect to a potential of the positive electrode and the potential of the positive electrode, for each predetermined diagnosis cycle; a Gaussian fitting step of generating a plurality of Gaussian curves that form a curve corresponding to the differential profile when combined with each other; a diagnosis information generating step of generating diagnosis information on a redox reaction amount of one or more elements among a plurality of different elements included in the active material using the plurality of Gaussian curves; and a diagnosing step of diagnosing the battery based on the diagnosis information.

## Description

### TECHNICAL FIELD

This application is based on and claims priority from Korean Patent Application No. 10-2024-0022841, filed on February 16, 2024, with the Korean Intellectual Property Office, the disclosure of which is incorporated herein in its entirety by reference.

The present disclosure relates to an apparatus and method for diagnosing a battery, and more particularly, to an apparatus and method for non-destructively diagnosing a state of a battery capable of charging and discharging.

### BACKGROUND ART

Recently, the demand for portable electronic products such as notebook computers, digital cameras and portable telephones has increased sharply, and electric vehicles, energy storage systems, robots, satellites and the like have been developed in earnest. Accordingly, high-performance batteries allowing charging and discharging and having high energy density are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries gradually deteriorate as the charge and discharge cycles are repeated, and they no longer maintain the electrical capacity they had at the time of manufacture but are deteriorated. Therefore, in order to accurately predict the usable time, remaining life, and replacement time of the battery, an accurate diagnosis of the battery state is required.

However, since the existing technology diagnoses the state of the battery through the SOH (State of Health) of the entire battery, when an active material such as Mn-rich that causes redox reaction and phase transformation is applied to the battery electrode, it is impossible to provide information on the redox reaction amount of the active material, and it is impossible to diagnose the state of the battery related to the redox reaction amount of the active material.

### DISCLOSURE

### Technical Problem

The technical challenge that the present disclosure seeks to solve is to provide an apparatus and method for diagnosing a battery, which may provide information on the redox reaction amount of an active material applied to a positive electrode of a battery and may diagnose the state of the battery related to the redox reaction amount of the active material.

Another technical challenge that the present disclosure seeks to solve is to provide an apparatus for diagnosing a battery, which may extend the life of the battery and improve safety.

### Technical Solution

A method for diagnosing a battery according to one aspect of the present disclosure diagnoses a battery having a positive electrode to which an active material is applied, and comprises: a differential profile generating step of generating a differential profile representing a corresponding relationship between a differential capacity obtained by differentiating a capacity of the positive electrode with respect to a potential of the positive electrode and the potential of the positive electrode, for each predetermined diagnosis cycle; a Gaussian fitting step of generating a plurality of Gaussian curves that form a curve corresponding to the differential profile when combined with each other; a diagnosis information generating step of generating diagnosis information on a redox reaction amount of one or more elements among a plurality of different elements included in the active material using the plurality of Gaussian curves; and a diagnosing step of diagnosing the battery based on the diagnosis information.

In an embodiment, the differential profile generating step may include a first generating step of measuring electrical values of the battery using an electrical sensor while the battery is being charged or discharged, and generating a battery profile representing a corresponding relationship between the capacity and a voltage of the battery based on the measured electrical values; a positive electrode profile obtaining step of obtaining a positive electrode profile representing a corresponding relationship between the capacity and the potential of the positive electrode based on the battery profile; and a second generating step of generating the differential profile by differentiating the positive electrode profile with respect to the potential of the positive electrode.

In an embodiment, the method for diagnosing a battery may further comprise storing a plurality of reference positive electrode profiles and a plurality of reference negative electrode profiles in a memory, before the differential profile generating step, and the positive electrode profile obtaining step may include selecting a reference positive electrode profile and a reference negative electrode profile that generate a profile most similar to the battery profile when combined with each other among the plurality of reference positive electrode profiles and the plurality of reference negative electrode profiles stored in the memory; and obtaining the selected reference positive electrode profile as the positive electrode profile.

In an embodiment, the diagnosis information generating step may include calculating a first quantification value obtained by quantifying the redox reaction amount of a first element based on a first Gaussian curve corresponding to the first element included in the active material among the plurality of Gaussian curves; calculating a second quantification value obtained by quantifying the redox reaction amount of a second element based on a second Gaussian curve corresponding to the second element included in the active material among the plurality of Gaussian curves; and generating the diagnosis information including the first quantification value and the second quantification value.

In an embodiment, the diagnosing step may include a redox ratio calculating step of calculating a redox ratio representing a ratio of the redox reaction amount of the second element to the redox reaction amount of the first element based on the first quantification value and the second quantification value included in the diagnosis information; and a determining step of determining a state of the battery based on the redox ratio.

In an embodiment, the determining step may include a step of determining the state of the battery by referring to a change trend of the redox ratio during a plurality of diagnosis cycles.

In an embodiment, the active material may include lithium manganese oxide, the first element may be manganese, and the second element may be oxygen.

In an embodiment, the determining step may further include a step of determining the state of the battery as an abnormal state when the change trend of the redox ratio changes from a decreasing trend to an increasing trend.

In an embodiment, the method for diagnosing a battery may further comprise adjusting a voltage at completion of charging of the battery or adjusting a current rate of a current that charges the battery by controlling a charger that charges the battery according to the diagnosis result in the diagnosing step.

An apparatus for diagnosing a battery according to another aspect of the present disclosure diagnoses a battery having a positive electrode to which an active material is applied, and comprises: a differential profile generating unit configured to generate a differential profile representing a corresponding relationship between a differential capacity obtained by differentiating a capacity of the positive electrode with respect to a potential of the positive electrode and the potential of the positive electrode, for each predetermined diagnosis cycle; a Gaussian fitting unit configured to generate a plurality of Gaussian curves that form a curve corresponding to the differential profile when combined with each other; a diagnosis information generating unit configured to generate diagnosis information on a redox reaction amount of one or more elements among a plurality of different elements included in the active material using the plurality of Gaussian curves; and a diagnosing unit configured to diagnose the battery based on the diagnosis information.

In an embodiment, the diagnosis information generating unit may be configured to calculate a first quantification value obtained by quantifying the redox reaction amount of a first element based on a first Gaussian curve corresponding to the first element included in the active material among the plurality of Gaussian curves and calculate a second quantification value obtained by quantifying the redox reaction amount of a second element based on a second Gaussian curve corresponding to the second element included in the active material among the plurality of Gaussian curves to generate the diagnosis information including the first quantification value and the second quantification value.

In an embodiment, the diagnosing unit may include a redox ratio calculating module configured to calculate a redox ratio representing a ratio of the redox reaction amount of the second element to the redox reaction amount of the first element based on the first quantification value and the second quantification value included in the diagnosis information; and a determining module configured to determine a state of the battery based on the redox ratio.

In an embodiment, the determination module may be configured to determine the state of the battery by referring to a change trend of the redox ratio during a plurality of diagnosis cycles.

A battery pack according to still another aspect of the present disclosure may comprise the apparatus for diagnosing a battery as described above.

A vehicle according to still another aspect of the present disclosure may comprise the apparatus for diagnosing a battery as described above.

### Advantageous Effects

The present disclosure may provide information on the redox reaction amount of an active material applied to the positive electrode of a battery by performing Gaussian fitting on a differential profile representing a corresponding relationship between a differential capacity obtained by differentiating the capacity of a positive electrode of a battery with respect to the potential of the positive electrode and the potential of the positive electrode to generate Gaussian curves corresponding to the differential profile and generating information on a redox reaction amount of an active material applied to the positive electrode using the Gaussian curves, and may diagnose the state of the battery related to the redox reaction amount of the active material.

In addition, the present disclosure may increase the accuracy and reliability of the diagnosis result by quantifying the redox reaction amount of elements forming the active material and providing a quantification value corresponding to the redox reaction amount.

In addition, the present disclosure may extend the life of the battery and improve safety by controlling the charging and/or discharging conditions of the battery according to the diagnosis result of the battery.

Furthermore, a person having ordinary skill in the art to which the present disclosure belongs will be able to clearly understand from the following description that various embodiments according to the present disclosure can solve various technical problems not mentioned above.

### DESCRIPTION OF DRAWINGS

FIG. 1 is a block diagram showing an apparatus for diagnosing a battery according to an embodiment of the present disclosure.
FIG. 2 is a drawing showing an example of a positive electrode profile map generated based on a positive electrode half-cell.
FIG. 3 is a drawing showing an example of a positive electrode profile map supplemented through simulation.
FIG. 4 is a drawing showing an example of a negative electrode profile map generated based on a negative electrode half-cell.
FIG. 5 is a drawing showing an example of a positive electrode profile and a negative electrode profile corresponding to a battery profile.
FIG. 6 is a drawing showing a differential profile obtained by differentiating the positive electrode profile with respect to the potential of the positive electrode.
FIG. 7 is a diagram showing Gaussian curves generated by performing Gaussian fitting on the differential profile shown in FIG. 6.
FIG. 8 is a graph showing a trend of changes in the redox reaction amount of elements included in the positive electrode active material as the number of charge/discharge cycles increases.
FIG. 9 is a graph showing a trend of changes in the redox ratio of manganese to oxygen as the number of charge/discharge cycles increases.
FIG. 10 is a flow chart showing a method for diagnosing a battery according to an embodiment of the present disclosure.
FIG. 11 is a drawing showing a battery pack according to an embodiment of the present disclosure.
FIG. 12 is a drawing showing a vehicle according to an embodiment of the present disclosure.

### BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted. In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

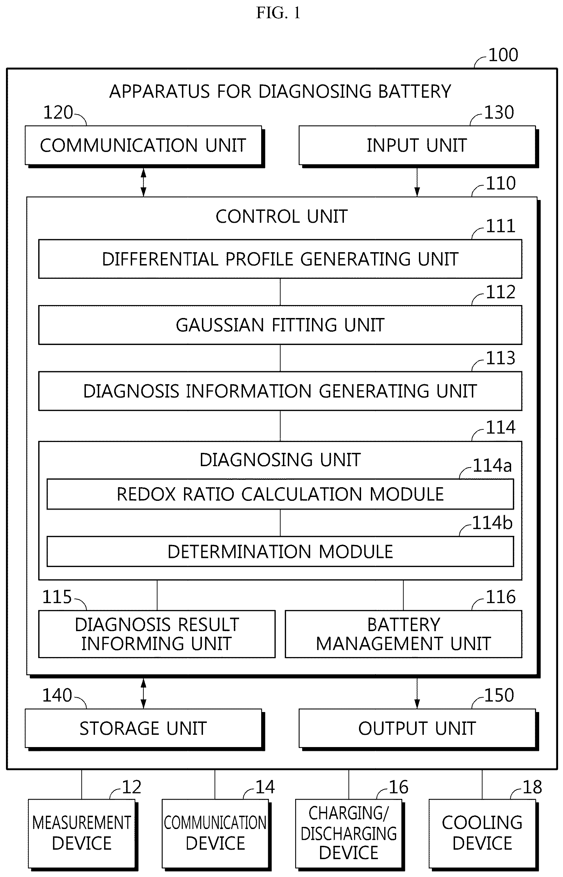

FIG. 1 is a block diagram showing an apparatus 100 for diagnosing a battery according to an embodiment of the present disclosure.

As illustrated in FIG. 1, the apparatus 100 for diagnosing a battery according to an embodiment of the present disclosure is configured to non-destructively diagnose a rechargeable battery. To this end, the apparatus 100 for diagnosing a battery includes a control unit 110. A target battery to be diagnosed in the present disclosure has a positive electrode and a negative electrode that are electrically insulated from each other by a separator. An active material including a plurality of different elements is applied to the positive electrode. For example, the active material may include lithium manganese oxide.

The control unit 110 may include one or more general-purpose processors or ASICs (application-specific integrated circuits) for executing the battery diagnosis logic, and may optionally further include hardware such as registers and memories according to an embodiment. The control unit 110 may be configured with a combination of hardware such as a processor and software such as a computer program. That is, the battery diagnosis logic of the control unit 110 may be configured as a computer program and stored in the memory of the control unit 110 or a storage unit 140 described below, and the stored computer program may be configured to be executed through the hardware of the control unit 110.

Meanwhile, the control unit 110 is a detailed component for diagnosing the battery assembly and includes a differential profile generating unit 111, a Gaussian fitting unit 112, a diagnosis information generating unit 113 and a diagnosing unit 114.

The differential profile generating unit 111 is configured to generate a differential profile representing a corresponding relationship between a differential capacity obtained by differentiating the capacity of the positive electrode of the target battery with respect to the potential of the positive electrode and the potential of the positive electrode, for each predetermined diagnosis cycle. In an embodiment, the diagnosis cycle may be set to be the same as the charge/discharge cycle of the target battery.

For example, the differential profile generating unit 111 may measure electrical values of the target battery using an electrical sensor while the target battery is being charged or discharged, and generate a battery profile representing a corresponding relationship between the capacity and voltage of the target battery based on the measured electrical values.

Then, the differential profile generating unit 111 may obtain a positive electrode profile representing a corresponding relationship between the capacity and potential of the positive electrode based on the battery profile.

For this purpose, the control unit 110 may store a plurality of reference positive electrode profiles and a plurality of reference negative electrode profiles in a predetermined memory before acquiring the positive electrode profile.

In this case, the differential profile generating unit 111 may select a reference positive electrode profile and a reference negative electrode profile that generate a profile most similar to the battery profile when combined with each other among the plurality of reference positive electrode profiles and the plurality of reference negative electrode profiles stored in the memory, and obtain the selected reference positive electrode profile as the positive electrode profile of the target battery.

The Gaussian fitting unit 112 is configured to perform Gaussian fitting on the differential profile to generate a plurality of Gaussian curves that form a curve corresponding to the differential profile when combined with each other.

The diagnosis information generating unit 113 is configured to generate diagnosis information regarding the redox reaction amount of one or more elements among the plurality of elements using the plurality of Gaussian curves.

For example, the diagnosis information generating unit 113 may calculate a first quantification value obtained by quantifying the redox reaction amount of the first element based on a first Gaussian curve corresponding to the first element included in the active material among the plurality of Gaussian curves. In this case, the diagnosis information generating unit 113 may calculate the first quantification value by integrating the first Gaussian curve with respect to the potential of the positive electrode over the entire potential range of the positive electrode.

In addition, the diagnosis information generating unit 113 may calculate a second quantification value obtained by quantifying the redox reaction amount of the second element based on a second Gaussian curve corresponding to the second element included in the active material among the plurality of Gaussian curves. In this case, the diagnosis information generating unit 113 may calculate the second quantification value by integrating the second Gaussian curve with respect to the potential of the positive electrode over the entire potential range of the positive electrode.

Also, the diagnosis information generating unit 113 may generate diagnosis information including the calculated first quantification value and second quantification value.

The diagnosing unit 114 is configured to diagnose a target battery based on the diagnosis information.

In an embodiment, the diagnosing unit 114 may include a redox ratio calculation module 114a and a determination module 114b.

In this case, the redox ratio calculation module 114a may be configured to calculate a redox ratio representing a ratio of a redox reaction amount of the second element to a redox reaction amount of the first element, based on the first quantification value and the second quantification value included in the diagnosis information.

The determination module 114b may be configured to determine the state of the target battery based on the redox ratio.

For example, the determination module 114b may determine the state of the target battery by referring to the change trend of the redox ratio during a plurality of diagnosis cycles.

In an embodiment, the active material applied to the positive electrode may be a manganese-rich (Mn-rich) active material, such as lithium manganese oxide.

In this case, the active material applied to the positive electrode may be represented by the following chemical formula 1.

**[Chemical formula 1]** Li₁₊ₐ[Ni_{b}Co_{c}Mn_{d}M¹ₑ]O₂₊ₐ

In the chemical formula 1, M¹ is at least one selected from the group consisting of metal ions Al, B, Co, W, Mg, V, Ti, Zn, Ga, In, Ru, Nb, Sn, Sr, and Zr, and 0 ≤ a ≤ 0.5, 0 ≤ b ≤ 0.5, 0 ≤ c ≤ 0.5, 0.5 ≤ d ≤ 1.0, 0 ≤ e ≤ 0.5, and b + c + d + e = 1.

That is, the active material applied to the positive electrode may be an active material in which the mole fraction of manganese (Mn) among all transition metals included in the active material excluding lithium (Li) is 50% or more.

In another embodiment, the active material applied to the positive electrode may be represented by the following chemical formula 2.

**[Chemical formula 2]** Li₁₊ₐ[Ni_{b}Co_{c}Mn_{d}M¹ₑ]O₂₊ₐ

In the chemical formula 2, M¹ is at least one selected from the group consisting of metal ions Al, B, Co, W, Mg, V, Ti, Zn, Ga, In, Ru, Nb, Sn, Sr, and Zr, and 0 ≤ a ≤ 0.4, 0 ≤ b ≤ 0.4, 0 ≤ c ≤ 0.4, 0.6 ≤ d ≤ 1.0, 0 ≤ e ≤ 0.5, and b + c + d + e = 1.

For example, the active material applied to the positive electrode may be an active material in which the mole fraction of manganese (Mn) among the total transition metals included in the active material excluding lithium (Li) is 60% or more. That is, the active material applied to the positive electrode may be a lithium manganese oxide such as Li₂MnO₃.

In this case, the redox ratio, which is a diagnostic factor of the target battery, may be the ratio of the redox reaction amount of oxygen to the redox reaction amount of manganese.

In addition, the determination module 114b may determine the state of the target battery as an abnormal state when the change trend of the redox ratio according to the increase in charge/discharge cycles changes from a decreasing trend to an increasing trend.

In an embodiment, the control unit 110 may further include a diagnosis result informing unit 115. In this case, the diagnosis result informing unit 115 may be configured to output a visual, auditory or audio-visual notification signal corresponding to the diagnosis result of the target battery by controlling a predetermined output device.

In an embodiment, the control unit 110 may further include a battery management unit 116. In this case, the battery management unit 116 may be configured to control a charging condition and/or a discharging condition of the target battery according to the diagnosis result of the diagnosing unit 114. That is, the battery management unit 116 may adjust the voltage at the completion of charging of the target battery or adjust the current rate of the current that charges the target battery by controlling a charger that charges the target battery.

For example, when the state of the target battery is diagnosed as an abnormal state, the battery management unit 116 may be configured to control the charger that charges the target battery to reduce the voltage when charging of the target battery is completed or reduce the current rate of the current that charges the target battery.

Meanwhile, the battery management unit 116 may be configured to control the cooling device 18 described later to lower the temperature of the target battery.

The differential profile generating unit 111, the Gaussian fitting unit 112, the diagnosis information generating unit 113, the diagnosing unit 114, the diagnosis result informing unit 115 and the battery management unit 116 of the above-described control unit 110 may be implemented as a combination of a processor and a program executed by the processor. In this case, the control unit 110 may be implemented as a single processor, or may be implemented as two or more processors that are interconnected.

In an embodiment, the apparatus 100 for diagnosing a battery may further include a communication unit 120. The communication unit 120 may be configured to receive data transmitted from a remotely located server or communication terminal via a wired and/or wireless communication network and transmit the data to the control unit 110, or transmit control signals, diagnostic data, etc. processed by the control unit 110 to the remotely located server or communication terminal. To this end, the communication unit 120 may include a communication modem that performs wired and/or wireless communication.

In an embodiment, the apparatus 100 for diagnosing a battery may further include an input unit 130. The input unit 130 may be configured to receive commands or data from a user or an administrator. For this purpose, the input unit 130 may include an input device such as a keyboard, operating buttons, or a touch panel.

In an embodiment, the apparatus 100 for diagnosing a battery may further include a storage unit 140. The storage unit 140 may be configured to store and manage data required for the operation of the apparatus 100 for diagnosing a battery. To this end, the storage unit 140 may include a memory. For example, the storage unit 140 may include one or two or more of a ROM, a RAM, an EEPROM, a register, a flash memory, a CD-ROM, a magnetic tape, a hard disk, a floppy disk, and an optical data recording device.

In an embodiment, the apparatus 100 for diagnosing a battery may further include an output unit 150. The output unit 150 may be configured to visually, audibly or audiovisually output a notification signal of the diagnosis result informing unit 115. For this purpose, the output unit 150 may include a visual output device such as a light-emitting diode, a monitor, a display panel or a touch screen. In addition, the output unit 150 may further include a sound generating device such as a speaker.

In an embodiment, the apparatus 100 for diagnosing a battery may be configured to be interlocked with a measurement device 12 for measuring voltage and/or current of a target battery, a communication device 14 for communicating with another device, a charging/discharging device 16 for charging and discharging a target battery, a cooling device 18 for cooling a target battery, etc.

In another embodiment, the apparatus 100 for diagnosing a battery according to the present disclosure may include one or more of the measurement device 12, the communication device 14, the charging/discharging device 16, and the cooling device 18 described above.

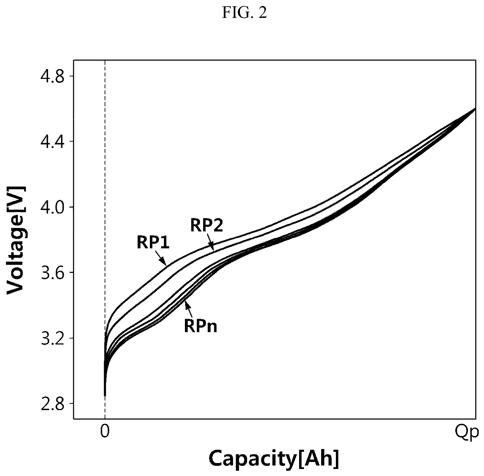

FIG. 2 is a drawing showing an example of a positive electrode profile map generated based on a positive electrode half-cell.

As illustrated in FIG. 2, the positive electrode profile map generated based on a positive electrode half-cell may include a plurality of reference positive electrode profiles RP1 to RPn.

The plurality of reference positive electrode profiles RP1 to RPn are profiles generated at different turns of charge/discharge cycles while the charge/discharge cycle of the positive electrode half-cell increases. In addition, each reference positive electrode profile represents a corresponding relationship between the capacity and voltage of the positive electrode half-cell at a corresponding turn of charge/discharge cycle.

In an embodiment, the positive electrode profile map may be a collection of reference positive electrode profiles generated while repeatedly charging and discharging the positive electrode half-cell at a low current rate of 0.05 [C].

In another embodiment, the positive electrode profile map may be a collection of reference positive electrode profiles generated while the positive electrode half-cell is charged and discharged at a low current rate of 0.05 [C], while repeating a process of charging and discharging the positive electrode half-cell once at a low current rate of 0.05 [C] and then charging and discharging several times at a high current rate of 0.5 [C]. In this case, since the gap between the reference positive electrode profiles becomes wider, the positive electrode profile map may be supplemented through simulation.

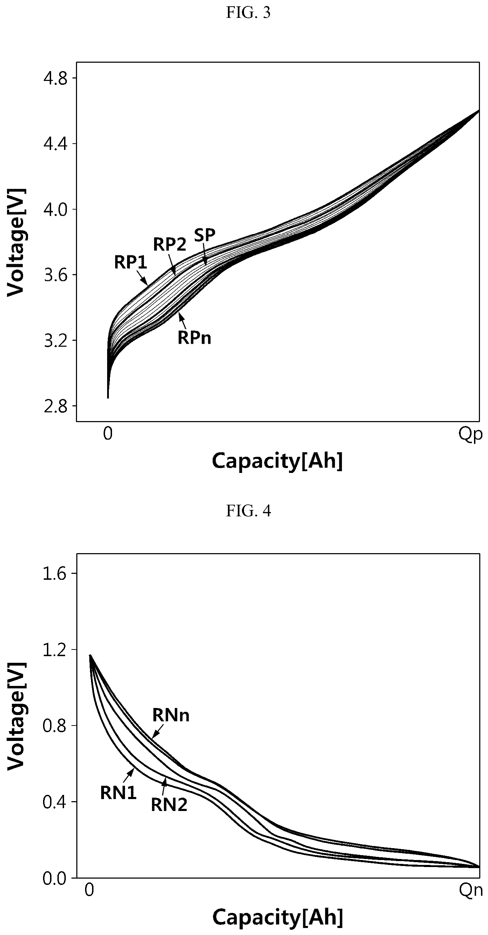

FIG. 3 is a drawing showing an example of a positive electrode profile map supplemented through simulation.

As illustrated in FIG. 3, if the reference positive electrode profiles generated while the positive electrode half-cell is charged and discharged at a low current rate of 0.05 [C], while repeating a process of charging and discharging the positive electrode half-cell once at a low current rate of 0.05 [C] and then charging and discharging several times at a high current rate of 0.5 [C], are collected to generate a positive electrode profile map, the gap between the collected reference positive electrode profiles becomes wider.

Therefore, the positive electrode profile map may be supplemented by inserting a simulation profile SP between the reference positive electrode profiles.

The positive electrode profile map or the reference positive electrode profiles generated in this manner may be stored in the memory of the storage unit 140 before the target battery is diagnosed.

FIG. 4 is a drawing showing an example of a negative electrode profile map generated based on a negative electrode half-cell.

As illustrated in FIG. 4, the negative electrode profile map generated based on a negative electrode half-cell may include a plurality of reference negative electrode profiles RN1 to RNn.

The plurality of reference negative electrode profiles RN1 to RNn are profiles generated at different turns of charge/discharge cycles while the charge/discharge cycle of the negative electrode half-cell increases. In addition, each reference negative electrode profile represents a corresponding relationship between the capacity and voltage of the negative electrode half-cell at a corresponding turn of charge/discharge cycle.

This negative electrode profile map may be generated in the same or similar manner as the positive electrode profile map described above.

Additionally, the negative electrode profile map or the reference negative electrode profiles may be stored in the memory of the storage unit 140 before the target battery is diagnosed.

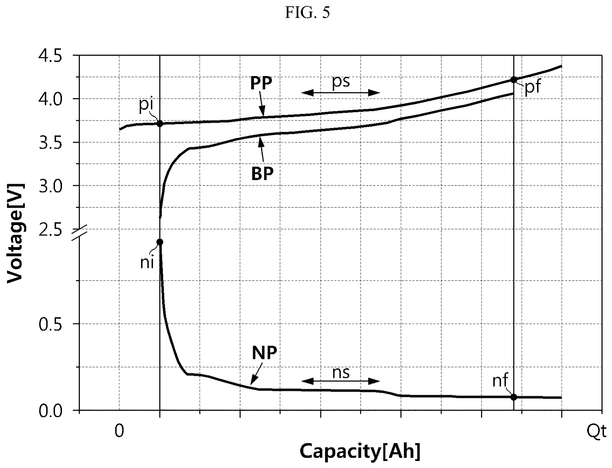

FIG. 5 is a drawing showing an example of a positive electrode profile PP and a negative electrode profile NP corresponding to a battery profile BP.

As illustrated in FIG. 5, the differential profile generating unit 111 may measure electrical values of the battery using an electrical sensor while the target battery is being charged or discharged, and generate a battery profile BP representing a relationship between the capacity and voltage of the target battery based on the measured electrical values.

Next, the differential profile generating unit 111 may select a reference positive electrode profile and a reference negative electrode profile that generate a profile most similar to the battery profile BP when combined among the plurality of reference positive electrode profiles and the plurality of reference negative electrode profiles stored in the memory, and obtain the selected reference positive electrode profile and reference negative electrode profile as the positive electrode profile PP and the negative electrode profile NP.

Meanwhile, the differential profile generating unit 111 may provide the start point (pi) and the end point (pf) of the positive electrode profile PP, the shrinkage ratio (ps) of the positive electrode profile PP compared with the selected reference positive electrode profile, the start point (ni) and the end point (nf) of the negative electrode profile NP, the shrinkage ratio (ns) of the negative electrode profile NP compared with the selected reference negative electrode profile, etc., to the diagnosis information generating unit 113. Then the diagnosing unit 114 may include the start point (pi), the end point (pf) and the shrinkage ratio (ps) of the positive electrode profile PP, and the start point (ni), the end point (nf) and the shrinkage ratio (ns) of the negative electrode profile NP in the diagnosis information as diagnostic factors indicating the state of the target battery.

Then, the differential profile generating unit 111 may generate the differential profile by differentiating the positive electrode profile PP with respect to the potential of the positive electrode.

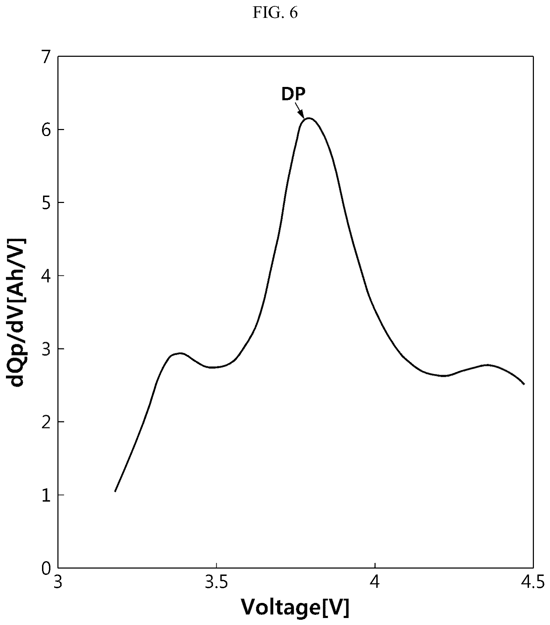

FIG. 6 is a drawing showing a differential profile DP obtained by differentiating the positive electrode profile with respect to the potential of the positive electrode.

As illustrated in FIG. 6, the differential profile DP may have a plurality of peaks located at different potential sections. The position and intensity of each peak are related to the redox reaction amount of elements included in the positive electrode active material.

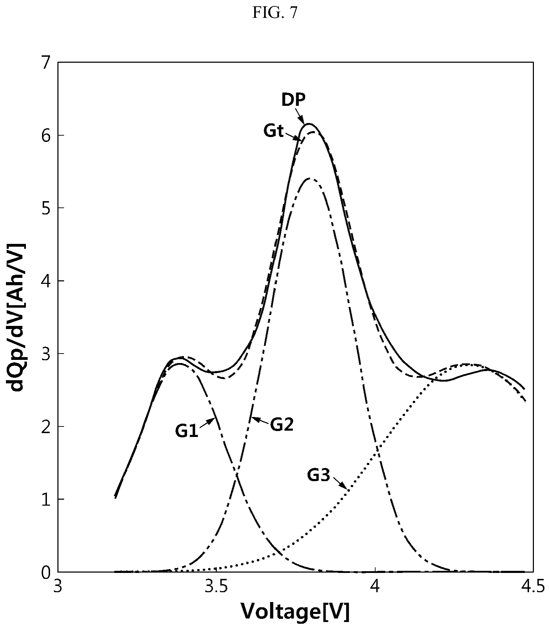

FIG. 7 is a diagram showing Gaussian curves generated by performing Gaussian fitting on the differential profile DP shown in FIG. 6.

As illustrated in FIG. 7, in order to quantify the redox reaction amount of elements included in the positive electrode active material, the Gaussian fitting unit 112 may generate a plurality of Gaussian curves G1, G2, G3 that form an approximation curve Gt corresponding to the differential profile DP when combined with each other by performing Gaussian fitting on the differential profile DP.

Then, the diagnosis information generating unit 113 may generate diagnosis information about the redox reaction amount of one or more elements among the plurality of elements included in the positive electrode active material by using the plurality of Gaussian curves G1, G2, G3.

The diagnosis information generating unit 113 is configured to generate diagnosis information regarding the redox reaction amount of one or more elements among the plurality of elements using the plurality of Gaussian curves.

For example, the diagnosis information generating unit 113 may select a first Gaussian curve corresponding to the first element included in the positive electrode active material among the plurality of Gaussian curves G1, G2, G3, and select a second Gaussian curve corresponding to the second element included in the positive electrode active material.

For reference, the selection of the Gaussian curve may be made based on the reaction potential of each element. For example, when the reaction potential of the first element is lower than 3.5 [V], the Gaussian curve G1 located in a potential section lower than 3.5 [V] among the plurality of Gaussian curves G1, G2, G3 may be selected as the first Gaussian curve corresponding to the first element. In addition, when the reaction potential of the second element is higher than 4 [V], the Gaussian curve G3 located in a potential section higher than 4 [V] among the plurality of Gaussian curves G1, G2, G3 may be selected as the second Gaussian curve corresponding to the second element.

In an embodiment, the first element may be manganese (Mn) and the second element may be oxygen (O).

Next, the diagnosis information generating unit 113 may calculate a first quantification value obtained by quantifying the redox reaction amount of the first element based on the first Gaussian curve G1. In this case, the diagnosis information generating unit 113 may calculate the first quantification value by integrating the first Gaussian curve G1 with respect to the potential of the positive electrode over the entire potential range of the positive electrode. That is, the redox reaction amount of the first element may be proportional to the area of the region between the horizontal axis representing the potential of the positive electrode and the first Gaussian curve G1.

In addition, the diagnosis information generating unit 113 may calculate a second quantification value obtained by quantifying the redox reaction amount of the second element based on the second Gaussian curve G3. In this case, the diagnosis information generating unit 113 may calculate the second quantification value by integrating the second Gaussian curve G3 with respect to the potential of the positive electrode over the entire potential range of the positive electrode. That is, the redox reaction amount of the second element may be proportional to the area of the region between the horizontal axis representing the potential of the positive electrode and the second Gaussian curve G3.

Next, the diagnosis information generating unit 113 may generate diagnosis information including the calculated first quantification value and second quantification value.

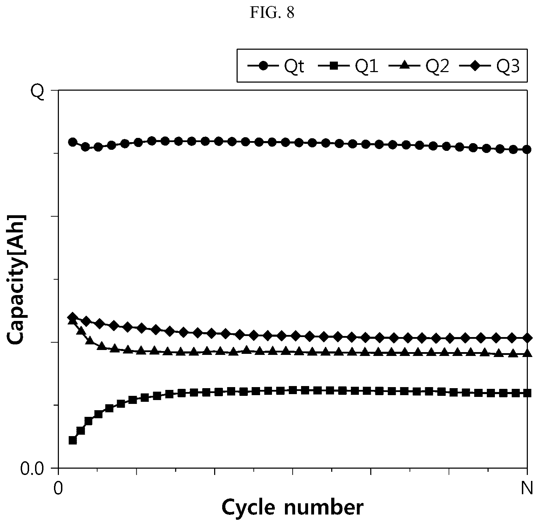

FIG. 8 is a graph showing a trend of changes in the redox reaction amount of elements included in the positive electrode active material as the number of charge/discharge cycles increases. For reference, FIG. 8 is a graph when the positive electrode active material includes manganese (Mn), nickel (Ni), and oxygen (O).

As shown in FIG. 8, the redox reaction amount graph Q1 of manganese (Mn) shows a trend of gradually increasing and then slightly decreasing as the number of charge/discharge cycles increases.

The redox reaction amount graph Q2 of nickel (Ni) and the redox reaction amount graph Q3 of oxygen (O) show a generally decreasing trend as the number of charge/discharge cycles increases.

As a result, the graph Qt of the sum of the redox reaction amounts of manganese (Mn), nickel (Ni), and oxygen (O) shows a trend of decreasing, then increasing for a while, and then decreasing again as the number of charge/discharge cycles increases.

The diagnosing unit 114 may calculate a redox ratio representing a ratio of the redox reaction amount of the second element to the redox reaction amount of the first element based on the first quantification value and the second quantification value, and determine the state of the target battery based on the calculated redox ratio.

For example, the diagnosing unit 114 may determine the state of the target battery by referring to the change trend of the redox ratio during a plurality of diagnosis cycles.

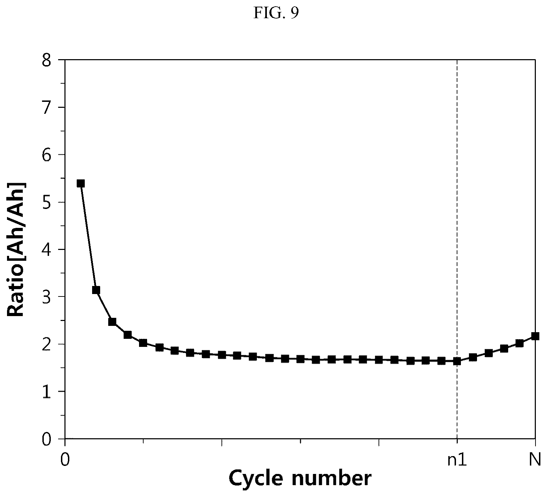

FIG. 9 is a graph showing a trend of changes in the redox ratio of manganese to oxygen as the number of charge/discharge cycles increases.

As shown in FIG. 9, the redox ratio, which represents the ratio of the redox reaction amount of oxygen to the redox reaction amount of manganese, generally shows a decreasing trend as the number of charge/discharge cycles increases. However, when the number of charge/discharge cycles becomes greater than n1, the redox ratio shows a gradually increasing trend.

In this way, when the change trend of the redox ratio changes from a decreasing trend to an increasing trend, the diagnosing unit 114 may determine that the state of the target battery is an abnormal state in which deterioration is in progress.

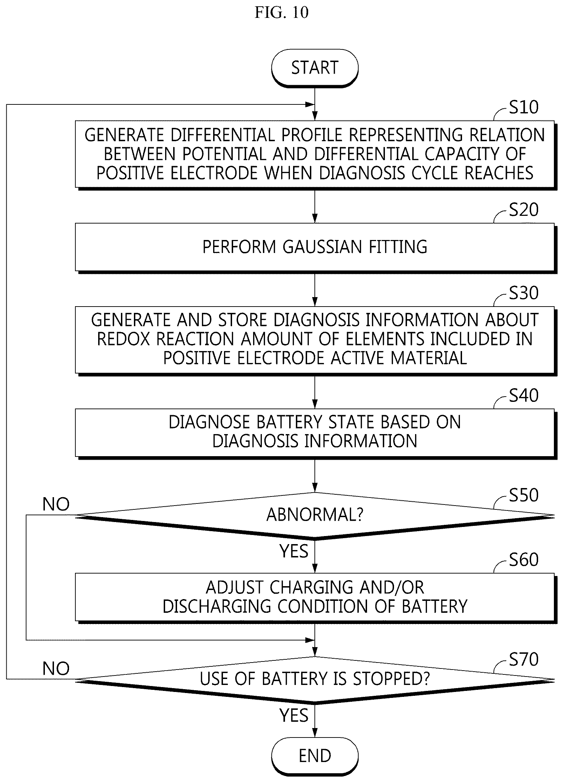

FIG. 10 is a flow chart showing a method for diagnosing a battery according to an embodiment of the present disclosure.

As illustrated in FIG. 10, the method for diagnosing a battery according to the present disclosure is a method for diagnosing a battery having a positive electrode to which an active material including a plurality of different elements is applied in a non-destructive manner, and may be performed by a processor.

First, the processor generates, for each predetermined diagnosis cycle, a differential profile that represents a corresponding relationship between a differential capacity, which is obtained by differentiating the capacity of the positive electrode of the target battery with respect to the potential of the positive electrode, and the potential of the positive electrode (S10). According to an embodiment, the diagnosis cycle may be set to be the same as the charge/discharge cycle of the target battery.

For example, the processor may measure electrical values of the target battery using an electrical sensor while the target battery is being charged or discharged, and generate a battery profile representing a corresponding relationship between the capacity and voltage of the target battery based on the measured electrical values.

Then, the processor may obtain a positive electrode profile representing a corresponding relationship between the capacity and potential of the positive electrode based on the battery profile.

For this purpose, the processor may store a plurality of reference positive electrode profiles and a plurality of reference negative electrode profiles in a predetermined memory before obtaining the positive electrode profile.

In this case, the processor may select a reference positive electrode profile and a reference negative electrode profile that, when combined with each other, generate a profile most similar to the battery profile among the plurality of reference positive electrode profiles and the plurality of reference negative electrode profiles stored in the memory, and obtain the selected reference positive electrode profile as the positive electrode profile of the target battery.

Next, the processor performs Gaussian fitting on the differential profile to generate a plurality of Gaussian curves that form a curve corresponding to the differential profile when combined with each other (S20).

Next, the processor generates diagnosis information about the redox reaction amount of one or more elements among the plurality of elements using the plurality of Gaussian curves and stores the diagnosis information in the memory (S30).

For example, the processor may calculate a first quantification value obtained by quantifying the redox reaction amount of the first element based on a first Gaussian curve corresponding to the first element included in the active material among the plurality of Gaussian curves. In this case, the processor may calculate the first quantification value by integrating the first Gaussian curve with respect to the potential of the positive electrode over the entire potential range of the positive electrode.

In addition, the processor may calculate a second quantification value obtained by quantifying the redox reaction amount of the second element based on a second Gaussian curve corresponding to the second element included in the active material among the plurality of Gaussian curves. In this case, the processor may calculate the second quantification value by integrating the second Gaussian curve with respect to the potential of the positive electrode over the entire potential range of the positive electrode.

Also, the processor may generate diagnosis information including the produced first quantification value and second quantification value.

Next, the processor diagnoses the target battery based on the diagnosis information (S40).

In an embodiment, the processor may calculate a redox ratio representing a ratio of a redox reaction amount of the second element to a redox reaction amount of the first element, based on the first quantification value and the second quantification value included in the diagnosis information.

Also, the processor may determine the state of the target battery based on the redox ratio.

For example, the processor may determine the state of the target battery by referring to the change trend of the redox ratio during a plurality of diagnosis cycles.

In an embodiment, the active material applied to the positive electrode of the target battery may be a manganese-rich (Mn-rich) active material, such as lithium manganese oxide.

In this case, the active material applied to the positive electrode may be represented by the chemical formula 1 or the chemical formula 2.

In addition, the redox ratio, which is a diagnostic factor of the target battery, may be the ratio of the redox reaction amount of oxygen to the redox reaction amount of manganese.

The processor may determine the state of the target battery as an abnormal state when the change trend of the redox ratio according to the increase in charge/discharge cycles changes from a decreasing trend to an increasing trend (S50).

Then, the processor may control the charging condition and/or discharging condition of the target battery according to the diagnosis result for the target battery (S60).

That is, the processor may adjust the voltage at the completion of charging of the target battery or adjust the current rate of the current that charges the target battery by controlling the charger that charges the target battery.

For example, if the state of the target battery is diagnosed as an abnormal state, the processor may be configured to control the charger that charges the target battery to reduce the voltage when charging of the target battery is completed or reduce the current rate of the current that charges the target battery.

Also, the processor may control the cooling device 18 described later to lower the temperature of the target battery.

Depending on an embodiment, the processor may output a visual, auditory or audio-visual notification signal corresponding to the diagnosis result of the target battery by controlling a predetermined output device.

Then, the processor may repeat the steps described above (S10 to S60) until the target battery is no longer in use (S70).

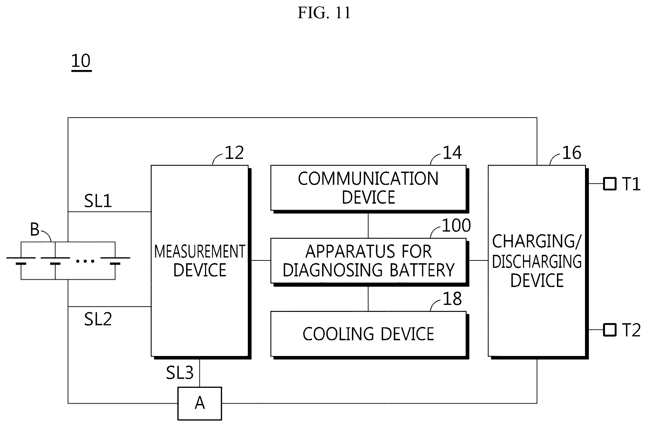

FIG. 11 is a drawing showing a battery pack 10 according to an embodiment of the present disclosure.

As illustrated in FIG. 11, the battery pack 10 includes a battery B allowing charging and discharging and the apparatus 100 for diagnosing a battery according to the present disclosure. In an embodiment, the battery pack 10 may optionally further include a measurement device 12, a communication device 14, a charging/discharging device 16, and a cooling device 18.

The measurement device 12 may be configured to measure the voltage and/or current of the battery B. To this end, the measurement device 12 may include at least one voltage sensor for sensing the voltage of the battery B and/or at least one current sensor for sensing the current of the battery B.

The measurement device 12 may measure the voltage of the battery B through the first sensing line SL1 and the second sensing line SL2. In addition, the measurement device 12 may measure the current of the battery B through the third sensing line SL3 connected to the current measurement circuit A. The current measurement circuit A may include a shunt resistor.

The apparatus 100 for diagnosing a battery according to an embodiment of the present disclosure may obtain electrical values of the battery B through the measurement device 12. For reference, the capacity of the battery B may be calculated by applying the current integration method to the current that charges the battery B.

The communication device 14 may be configured to perform communication with another device located remotely. For example, the communication device 14 may be configured to receive data transmitted from a remote server or communication terminal through a wired and/or wireless communication network and transmit the data to the apparatus 100 for diagnosing a battery, or transmit data generated in the apparatus 100 for diagnosing a battery to another server or communication terminal. To this end, the communication device 14 may include a communication modem that performs wired communication and/or wireless communication.

The charging/discharging device 16 may be configured to charge and/or discharge the battery B. To this end, the charging/discharging device 16 may include a charger for charging the battery B, a discharger for discharging the battery B, at least one switch for electrically connecting the battery B to terminals T1, T2 of the battery pack 10, etc.

The apparatus 100 for diagnosing a battery according to an embodiment of the present disclosure may control the charging/discharging device 16 to perform or stop charging or discharging of the battery B, set charging/discharging conditions, or change the set charging/discharging conditions.

The cooling device 18 may be configured to cool the battery B. To this end, the cooling device 18 may include a heat sink that absorbs heat from the battery B and releases it to the outside.

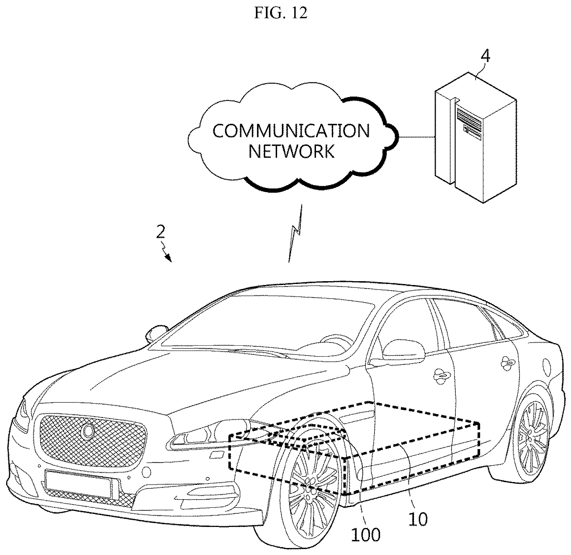

FIG. 12 is a drawing showing a vehicle according to an embodiment of the present disclosure.

As illustrated in FIG. 12, the vehicle 2 according to an embodiment of the present disclosure may include a battery pack 10 that provides electrical energy necessary for the operation of the vehicle and the apparatus 100 for diagnosing a battery according to the present disclosure.

In this case, the apparatus 100 for diagnosing a battery may be configured to interact with an ECU (Electronic Control Unit) that controls the operation of the vehicle 2 or a BMS (Battery Management System) of the battery pack 10.

Additionally, the apparatus 100 for diagnosing a battery may be configured to receive data transmitted from a remote server 4 via a wired and/or wireless communication network, or to transmit data generated by the apparatus 100 for diagnosing a battery to the server 4.

For reference, the apparatus 100 for diagnosing a battery according to the present disclosure may be applied to various electrical devices or electrical systems other than vehicles, as well as to ESS (Energy Storage System).

As described above, the present disclosure may provide information on the redox reaction amount of an active material applied to the positive electrode of a battery by performing Gaussian fitting on a differential profile representing a corresponding relationship between a differential capacity obtained by differentiating the capacity of a positive electrode of a battery with respect to the potential of the positive electrode and the potential of the positive electrode to generate Gaussian curves corresponding to the differential profile and generating information on a redox reaction amount of an active material applied to the positive electrode using the Gaussian curves, and may diagnose the state of the battery related to the redox reaction amount of the active material.

In addition, the present disclosure may increase the accuracy and reliability of the diagnosis result by quantifying the redox reaction amount of elements forming the active material and providing a quantification value corresponding to the redox reaction amount.

In addition, the present disclosure may extend the life of the battery and improve safety by controlling the charging and/or discharging conditions of the battery according to the diagnosis result of the battery.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. In other words, the true technical scope of the present disclosure is indicated by the claims, and all differences within the scope equivalent thereto should be interpreted as being included in the present disclosure.

### [Explanation of reference signs]

2: vehicle
10: battery pack
100: apparatus for diagnosing a battery
110: control unit
111: differential profile generating unit
112: Gaussian fitting unit
113: diagnosis information generating unit
114: diagnosing unit
115: diagnosis result informing unit
116: battery management unit
120: communication unit
130: input unit
140: storage unit
150: output unit

## Claims

1. A method for diagnosing a battery, which diagnoses a battery having a positive electrode to which an active material is applied, the method comprising:
a differential profile generating step of generating a differential profile representing a corresponding relationship between a differential capacity obtained by differentiating a capacity of the positive electrode with respect to a potential of the positive electrode and the potential of the positive electrode, for each predetermined diagnosis cycle;
a Gaussian fitting step of generating a plurality of Gaussian curves that form a curve corresponding to the differential profile when combined with each other;
a diagnosis information generating step of generating diagnosis information on a redox reaction amount of one or more elements among a plurality of different elements included in the active material using the plurality of Gaussian curves; and
a diagnosing step of diagnosing the battery based on the diagnosis information.

2. The method for diagnosing a battery according to claim 1,
wherein the differential profile generating step includes:
a first generating step of measuring electrical values of the battery using an electrical sensor while the battery is being charged or discharged, and generating a battery profile representing a corresponding relationship between the capacity and a voltage of the battery based on the measured electrical values;
a positive electrode profile obtaining step of obtaining a positive electrode profile representing a corresponding relationship between the capacity and the potential of the positive electrode based on the battery profile; and
a second generating step of generating the differential profile by differentiating the positive electrode profile with respect to the potential of the positive electrode.

3. The method for diagnosing a battery according to claim 2, further comprising:
storing a plurality of reference positive electrode profiles and a plurality of reference negative electrode profiles in a memory, before the differential profile generating step,
wherein the positive electrode profile obtaining step includes:
selecting a reference positive electrode profile and a reference negative electrode profile that generate a profile most similar to the battery profile when combined with each other among the plurality of reference positive electrode profiles and the plurality of reference negative electrode profiles stored in the memory; and
obtaining the selected reference positive electrode profile as the positive electrode profile.

4. The method for diagnosing a battery according to claim 1,
wherein the diagnosis information generating step includes:
calculating a first quantification value obtained by quantifying the redox reaction amount of a first element based on a first Gaussian curve corresponding to the first element included in the active material among the plurality of Gaussian curves;
calculating a second quantification value obtained by quantifying the redox reaction amount of a second element based on a second Gaussian curve corresponding to the second element included in the active material among the plurality of Gaussian curves; and
generating the diagnosis information including the first quantification value and the second quantification value.

5. The method for diagnosing a battery according to claim 4,
wherein the diagnosing step includes:
a redox ratio calculating step of calculating a redox ratio representing a ratio of the redox reaction amount of the second element to the redox reaction amount of the first element based on the first quantification value and the second quantification value included in the diagnosis information; and
a determining step of determining a state of the battery based on the redox ratio.

6. The method for diagnosing a battery according to claim 5,
wherein the determining step includes a step of determining the state of the battery by referring to a change trend of the redox ratio during a plurality of diagnosis cycles.

7. The method for diagnosing a battery according to claim 6,
wherein the active material includes lithium manganese oxide,
wherein the first element is manganese, and
wherein the second element is oxygen.

8. The method for diagnosing a battery according to claim 7,
wherein the determining step further includes a step of determining the state of the battery as an abnormal state when the change trend of the redox ratio changes from a decreasing trend to an increasing trend.

9. The method for diagnosing a battery according to claim 1, further comprising:
adjusting a voltage at completion of charging of the battery or adjusting a current rate of a current that charges the battery by controlling a charger that charges the battery according to the diagnosis result in the diagnosing step.

10. An apparatus for diagnosing a battery, which diagnoses a battery having a positive electrode to which an active material is applied, the apparatus comprising:
a differential profile generating unit configured to generate a differential profile representing a corresponding relationship between a differential capacity obtained by differentiating a capacity of the positive electrode with respect to a potential of the positive electrode and the potential of the positive electrode, for each predetermined diagnosis cycle;
a Gaussian fitting unit configured to generate a plurality of Gaussian curves that form a curve corresponding to the differential profile when combined with each other;
a diagnosis information generating unit configured to generate diagnosis information on a redox reaction amount of one or more elements among a plurality of different elements included in the active material using the plurality of Gaussian curves; and
a diagnosing unit configured to diagnose the battery based on the diagnosis information.

11. The apparatus for diagnosing a battery according to claim 10,
wherein the diagnosis information generating unit is configured to calculate a first quantification value obtained by quantifying the redox reaction amount of a first element based on a first Gaussian curve corresponding to the first element included in the active material among the plurality of Gaussian curves and calculate a second quantification value obtained by quantifying the redox reaction amount of a second element based on a second Gaussian curve corresponding to the second element included in the active material among the plurality of Gaussian curves to generate the diagnosis information including the first quantification value and the second quantification value.

12. The apparatus for diagnosing a battery according to claim 11,
wherein the diagnosing unit includes:
a redox ratio calculating module configured to calculate a redox ratio representing a ratio of the redox reaction amount of the second element to the redox reaction amount of the first element based on the first quantification value and the second quantification value included in the diagnosis information; and
a determining module configured to determine a state of the battery based on the redox ratio.

13. The apparatus for diagnosing a battery according to claim 12,
wherein the determination module is configured to determine the state of the battery by referring to a change trend of the redox ratio during a plurality of diagnosis cycles.

14. A battery pack comprising the apparatus for diagnosing a battery according to any one of claims 10 to 13.

15. A vehicle comprising the apparatus for diagnosing a battery according to any one of claims 10 to 13.
